(19) **Europäisches Patentamt**
**European Patent Office**
**Office européen des brevets**

(11) **EP 1 646 147 B1**

(12) **FASCICULE DE BREVET EUROPÉEN**

(45) Date de publication et mention
de la délivrance du brevet:
**12.12.2007 Bulletin 2007/50**

(51) Int Cl.:
***H03H 15/00*** *(2006.01)*

(21) Numéro de dépôt: **05109262.5**

(22) Date de dépôt: **05.10.2005**

(54) **Filtre analogique à composants passifs pour signaux à temps discret**

Analoges Filter für zeitdiskrete Signale aus passiven Bauelementen

Analog filter for time discrete signals based on passive components

(84) Etats contractants désignés:
**FR GB**

(30) Priorité: **06.10.2004 FR 0452279**

(43) Date de publication de la demande:
**12.04.2006 Bulletin 2006/15**

(73) Titulaire: **ST MICROELECTRONICS S.A.**
**92120 Montrouge (FR)**

(72) Inventeurs:
• **Belveze, Fabrice**
**38120 Fontanil-Cornillon (FR)**

• **Garcia, Luc**
**38760, Saint Paul de Varces (FR)**

(74) Mandataire: **de Beaumont, Michel et al**
**1bis, rue Champollion**
**38000 Grenoble (FR)**

(56) Documents cités:
**US-A- 5 325 322          US-A1- 2003 083 033**
**US-A1- 2004 102 908          US-B1- 6 177 897**

Printed by Jouve, 75001 PARIS (FR)

**Description**

Domaine de l'invention

La présente invention concerne les filtres analogiques pour signaux à temps discret. Par signal à temps discret, on entend un signal obtenu, par exemple, par échantillonnage d'un signal analogique initial à une fréquence d'échantillonnage déterminée, et correspondant donc à une suite d'échantillons du signal analogique non encore convertis sous forme binaire.

Exposé de l'art antérieur

Dans le domaine du traitement de signal, il peut être souhaitable de réaliser une opération de filtrage sur un signal à temps discret obtenu avant que le signal à temps discret ne soit converti sous forme binaire. Une telle opération de filtrage permet, par exemple, de limiter la largeur de bande du signal à temps discret, notamment pour éviter un repliement du spectre du signal lorsqu'une décimation est réalisée sur les échantillons du signal à temps discret avant conversion analogique-numérique. Le filtrage permet également d'éliminer le bruit à large bande qui se trouve à l'extérieur de la bande intéressante, ou d'éliminer des composantes en fréquence indésirables de forte amplitude, comme cela peut être le cas pour un récepteur radio.

Le filtrage d'un signal à temps discret peut être réalisé par un filtre analogique actif à capacités commutées. Il s'agit par exemple des filtres décrits dans la publication de G.M. Jacobs et al intitulée "Design Techniques for MOS Switch Capacitor Ladder Filters", IEEE Transactions on Circuits and Systems, vol. CAS-25, décembre 1978, pages 1014-1021. Toutefois, de tels filtres utilisent des amplificateurs opérationnels, ce qui peut être un inconvénient, en particulier pour des systèmes pour lesquels la consommation doit être la plus faible possible ou pour lesquels la fréquence d'échantillonnage est élevée, comme cela est par exemple le cas pour les récepteurs radio.

Il est donc souhaitable d'utiliser un filtre à composants uniquement passifs. A titre d'exemple, un filtre réalisant une moyenne glissante sur les derniers échantillons du signal à temps discret permet généralement d'obtenir un filtrage efficace. Un tel filtre est appelé filtre SINC, puisque l'expression de la transformée de Fourier du filtre est proche d'un sinus cardinal.

La demande de brevet américain 2003/0083033 déposée par la société Texas Instruments décrit un dispositif de traitement d'un signal à temps discret réalisant une opération de décimation, comprenant seulement des composants passifs et comportant un filtre SINC placé devant un module de décimation qui est lui-même suivi par un filtre à pôle unique.

Même si un tel circuit permet de limiter en partie le repliement du spectre, l'atténuation obtenue par le filtre SINC aux fréquences de repliement peut être insuffisante pour certaines applications. En outre, le filtre à pôle unique prévu en aval du module de décimation intervient trop tard, puisque, suite à l'opération de décimation, le repliement du spectre du signal fourni par le filtre SINC s'est déjà produit.

En particulier, pour des applications pour des récepteurs cellulaires, tels que des récepteurs du type GSM (acronyme anglais pour Global System for Mobile Communications correspondant à l'expression système global de communications mobiles) ou de type WCDMA (acronyme anglais pour Wideband Code Division Multiple Access correspondant à l'expression accès multiple par répartition en code à large bande), il est nécessaire de prévoir une atténuation suffisante des fréquences susceptibles de se replier lors d'une opération de décimation, ce qui ne peut généralement être obtenue que par l'intermédiaire d'un seul filtre SINC.

La présente invention vise à proposer une structure originale de filtre analogique pour signal à temps discret permettant de réaliser facilement n'importe quel filtre à réponse impulsionnelle finie et quasiment n'importe quel filtre à réponse impulsionnelle infinie.

Résumé de l'invention

Pour atteindre cet objet, la présente invention prévoit un filtre destiné à recevoir, sur une borne d'entrée, un signal à temps discret à une fréquence d'horloge d'échantillonnage, comprenant au moins un étage de filtrage comportant un nombre déterminé, supérieur à 2, de modules de filtrage, chaque module de filtrage comprenant des condensateurs de tête en nombre égal au nombre déterminé, montés en parallèle entre la borne d'entrée et la borne d'un condensateur d'intégration reliée à une borne de sortie de l'étage de filtrage ; et des moyens pour relier, au cours de cycles d'horloge successifs en nombre égal au nombre déterminé, successivement chaque condensateur de tête à la borne d'entrée, et pour alors relier simultanément les condensateurs de tête au condensateur d'intégration, et dans lequel les cycles d'horloge successifs au cours desquels les condensateurs de tête d'un module de filtrage sont reliés à la borne d'entrée sont décalés d'un cycle d'horloge d'un module de filtrage au suivant.

Selon un mode de réalisation de l'invention, le filtre comprend des moyens pour relier successivement chaque condensateur d'intégration à la borne de sortie à la fréquence d'échantillonnage.

Selon un mode de réalisation de l'invention, le filtre comprend, en outre, pour chaque module de filtrage, un étage de décimation relié à la borne de sortie de l'étage de filtrage, et comprend un condensateur, l'étage de filtrage comprenant des moyens pour relier simultanément les condensateurs d'intégration au condensateur de l'étage de décimation.

Selon un mode de réalisation de l'invention, le filtre comprend, pour chaque module de filtrage, des moyens pour mettre à une valeur constante déterminée la charge stockée dans chaque condensateur de tête après que les condensateurs de tête sont reliés au condensateur d'intégration.

Selon un mode de réalisation de l'invention, les capacités des condensateurs de tête sont identiques pour tous les modules de filtrage, ledit étage de filtrage réalisant un filtrage à moyenne glissante non pondérée.

Selon un mode de réalisation de l'invention, le filtre comprend, pour chaque module de filtrage, des moyens pour mettre à une valeur constante déterminée la charge stockée dans le condensateur d'intégration après que le condensateur d'intégration est relié à la borne de sortie.

Selon un mode de réalisation de l'invention, pour chaque module de filtrage, les capacités des condensateurs de tête sont différentes, les modules de filtrage étant identiques, ledit étage de filtrage réalisant un filtrage à moyenne glissante pondérée.

Selon un mode de réalisation de l'invention, le filtre comprend, pour au moins un condensateur de tête de chaque module de filtrage, un moyen pour, lorsque ledit condensateur de tête est relié simultanément avec les autres condensateurs de tête du module de filtrage au condensateur d'intégration du module de filtrage, fournir au condensateur d'intégration l'inverse de la charge du condensateur de tête.

Selon un mode de réalisation de l'invention, le filtre comprend un condensateur supplémentaire unique comportant une borne connectée à la borne d'entrée et une autre borne connectée à une source d'un potentiel de référence, la charge stockée dans le condensateur supplémentaire unique n'étant pas remise à une valeur constante déterminée au cours du fonctionnement du filtre.

Selon un mode de réalisation de l'invention, le filtre comprend, pour chaque module de filtrage, un condensateur supplémentaire monté en parallèle aux condensateurs de tête, et des moyens, pendant tous les cycles d'horloge successifs au cours desquels les condensateurs de tête sont reliés à la borne d'entrée, pour relier le condensateur supplémentaire à la borne d'entrée, la charge stockée dans le condensateur supplémentaire n'étant pas remise à zéro après que les condensateurs de tête sont reliés au condensateur d'intégration.

Selon un mode de réalisation de l'invention, le filtre comprend, pour chaque module de filtrage, des condensateurs de tête auxiliaires en nombre égal au nombre déterminé, montés en parallèle entre la borne d'entrée et la borne d'un condensateur d'intégration auxiliaire reliée à une borne de sortie auxiliaire de l'étage de filtrage ; et des moyens pour, au cours des cycles d'horloge successifs en nombre égal au nombre déterminé qui suivent les cycles d'horloge successifs au cours desquels les condensateurs de tête sont reliés à la borne d'entrée, relier successivement chaque condensateur de tête auxiliaire à la borne d'entrée, et pour alors relier simultanément les condensateurs de tête auxiliaires au condensateur d'intégration auxiliaire.

Brève description des dessins

Cet objet, ces caractéristiques et avantages, ainsi que d'autres de la présente invention seront exposés en détail dans la description suivante d'un exemple de réalisation particulier faite à titre non-limitatif en relation avec les figures jointes parmi lesquelles :

la figure 1 représente, de façon schématique, certains composants d'un récepteur radiofréquence ;
la figure 2 représente un exemple de réalisation d'un filtre selon la présente invention ;
la figure 3 représente des chronogrammes de signaux de commande du filtre de la figure 2 ;
les figures 4 à 7 représentent des variantes du filtre selon l'invention ; et
les figures 8 et 9 représentent des exemples de réalisation de circuits permettant de modifier la fonction de transfert du filtre selon l'invention.

Description détaillée

La présente demande va être décrite pour un filtre analogique de signaux à temps discret utilisé dans une application de réception radiofréquence. Toutefois, comme cela sera précisé plus en détail par la suite, la présente invention peut s'appliquer à la réalisation de tout type de filtre analogique de signaux à temps discret.

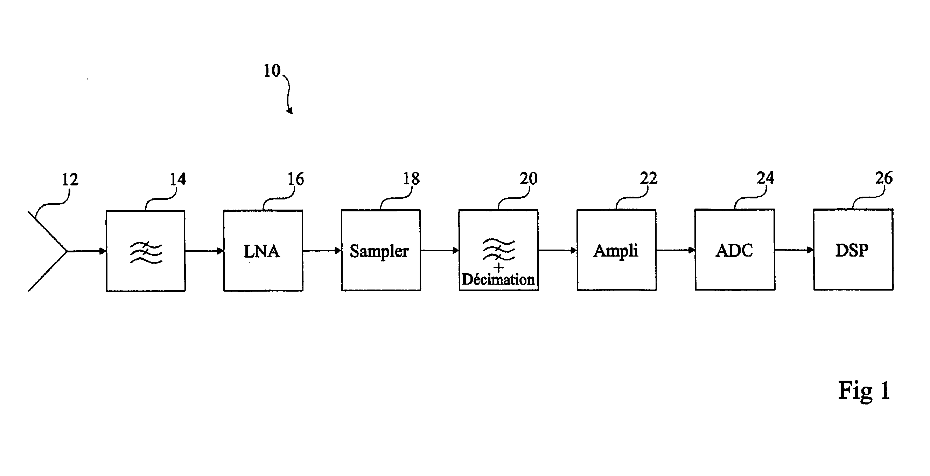

La figure 1 représente un exemple de réalisation d'un récepteur radiofréquence 10 comprenant une antenne 12 fournissant un signal analogique modulé en haute fréquence à un filtre passe-bande 14 qui réalise un premier filtrage grossier sur le signal modulé. Le signal filtré attaque un amplificateur à faible bruit 16, noté LNA (acronyme anglais pour Low Noise Amplifier). Le signal amplifié fourni par l'amplificateur à faible bruit 16 attaque un échantillonneur 18 qui fournit, à une fréquence d'échantillonnage $f_S$, un signal à temps discret constitué d'une suite d'échantillons du signal amplifié. L'opération d'échantillonnage permet parallèlement un transfert du signal en bande de base. Les valeurs échantillonnées sont fournies à un module de filtrage et de décimation 20 selon la présente invention, qui sera décrit plus en détail par la suite et qui réalise à la fois une opération de filtrage et une opération de décimation. Le signal à temps discret filtré et sous-échantillonné fourni par le module de filtrage et de décimation 20 attaque un amplificateur 22. Un convertisseur analogique-numérique 24, noté ADC (acronyme anglais pour Analog Digital Converter) reçoit le signal amplifié fourni par l'amplificateur 22 et fournit des valeurs numériques à un module de traitement de signaux numériques 26, noté DSP (acronyme anglais pour Digital Signal Processor).

Dans le présent exemple de réalisation, un filtre réalise une moyenne glissante, à l'ordre P (c'est-à-dire cascadée P fois), sur les M derniers échantillons du signal échantillonné à la fréquence d'échantillonnage $f_S$. L'entier M correspond à la longueur du filtre à l'ordre 1. La fonction de transfert d'un tel filtre est la suivante :

$$H(z) = (1 + z^{-1} + z^{-2} + \dots + z^{-M+1})^P = \left( \sum_{i=0}^{M-1} z^{-1} \right)^P = \left( \frac{1 - z^{-M}}{1 - z^{-1}} \right)^P$$

Ceci correspond à la transformée de Fourier suivante :

$$H(f) = \left( e^{-j\pi(M-1)f/f_S} \, \frac{\sin(\pi M f / f_S)}{\sin(\pi f / f_S)} \right)^P$$

La transformée de Fourier étant proche d'un sinus cardinal élevée à la puissance P, un tel filtre est appelé filtre SINC d'ordre P.

La présente invention prévoit une structure originale d'un étage de filtre, appelé par la suite étage général de filtre. Chaque étage général de filtre réalise, dans le présent exemple de réalisation, un filtrage SINC d'ordre 1 sur les M derniers échantillons du signal à temps discret. Pour obtenir un filtre d'ordre P, il suffit de mettre en cascade P étages généraux de filtre.

Toutefois, dans le présent exemple de réalisation, le module de filtrage et de décimation 20 permet de réaliser simultanément à l'opération de filtrage une opération de décimation. Dans ce cas, le rapport de décimation, correspondant au nombre d'échantillons reçus pour un échantillon fourni, est égal à la longueur du filtre élémentaire d'ordre 1, c'est-à-dire M. Pour ce faire, le module de filtrage et de décimation 20 se compose de P étages mis en cascade, les P-1 premiers étages correspondant chacun à un étage général de filtre et le dernier étage du filtre correspondant à un étage particulier appelé par la suite étage terminal de décimation. En outre, pour un tel module 20 qui réalise également une opération de décimation, l'avant-dernier étage du filtre, dont la structure correspond à celle d'un étage général de filtre, est commandé de façon particulière par rapport aux autres étages généraux de filtre.

De façon plus générale, pour réaliser un filtre SINC d'ordre 1 ne réalisant pas d'opération de décimation, on utilise un seul étage correspondant à l'étage général de filtre. Pour réaliser un filtre SINC d'ordre 2 réalisant une opération de décimation, on utilise deux étages, un premier étage général commandé de façon spécifique, et un étage terminal de décimation. Pour réaliser un filtre SINC d'ordre 3 réalisant une opération de décimation, on utilise trois étages, un étage général de filtre commandé de façon classique, un étage général de filtre commandé de façon spécifique pour l'opération de décimation, et un étage terminal de décimation.

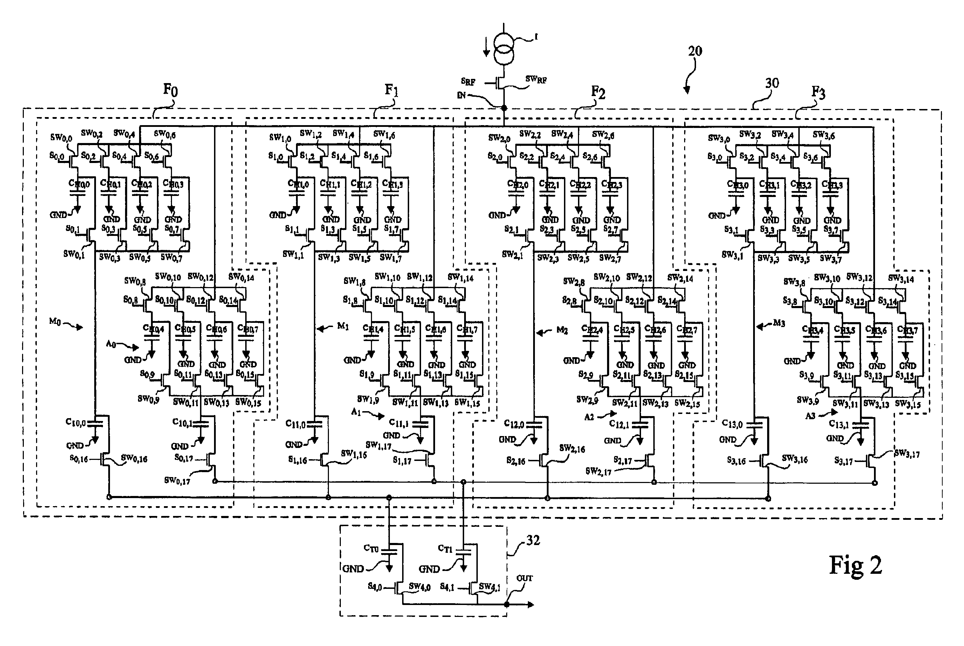

La figure 2 représente un exemple de réalisation d'un module de filtrage et de décimation 20 pour lequel P = 2 et M = 4 adapté à réaliser, simultanément à l'opération de filtrage, une opération de décimation.

En figure 2, on a représenté une source de courant I qui correspond, par exemple, au dernier étage de l'amplificateur à faible bruit 16 de la figure 1. La source de courant I délivre un courant dont l'intensité est proportionnelle à l'amplitude du signal analogique à traiter. Un interrupteur $SW_{RF}$, commandé par un signal $S_{RF}$, est prévu entre la source de courant I et le module 20 selon la présente invention. L'interrupteur $SW_{RF}$ correspond à l'échantillonneur 18 de la figure 1. Le signal $S_{RF}$ correspond à un signal carré dont la fréquence est la fréquence d'échantillonnage $f_S$.

Le module 20 comprend un premier étage 30 dont la structure correspond à la structure de l'étage général de filtre et un second étage 32 correspondant à l'étage terminal de décimation. Le module 20 comprend une borne d'entrée IN et une borne de sortie OUT. Le premier étage 30 comprend M modules de filtrage notés $F_i$, i étant un entier variant de 0 à M-1. Les modules de filtrage $F_i$ sont identiques. Chaque module de filtrage $F_i$ comprend un module principal Mi et un module auxiliaire $A_i$ qui ont des structures identiques. Le module principal Mi comprend M condensateurs de tête

$C_{Hi,j}$, j étant un entier variant de 0 à M-1. Les capacités des condensateurs $C_{Hi,j}$ sont identiques. Chaque condensateur $C_{Hi,j}$ a une première borne reliée à un potentiel de référence, par exemple la masse GND, et une seconde borne reliée à une première borne d'un interrupteur $SW_{i,2j}$. Les secondes bornes des interrupteurs $SW_{i,2j}$ sont reliées en commun à la borne d'entrée IN du module 20. Chaque interrupteur $SW_{i,2j}$ est commandé par un signal de commande $S_{i,2j}$. Un point milieu entre le condensateur $C_{Hi,j}$ et l'interrupteur associé $SW_{i,2j}$ est relié à une première borne d'un interrupteur $SW_{i,2j+1}$, commandé par un signal de commande $S_{i,2j+1}$. Les secondes bornes des interrupteurs $SW_{i,2j+1}$ sont reliées en commun à une première borne d'un condensateur $C_{Ii,0}$ dont la seconde borne est reliée au potentiel de référence GND. La première borne du condensateur $C_{Ii,0}$ est reliée à une première borne d'un interrupteur $SW_{i,4M}$, commandé par un signal de commande $S_{i,4M}$. Les secondes bornes des interrupteurs $SW_{i,4M}$, i variant de 0 à M-1, sont reliées à un noeud $N_1$.

Le module auxiliaire $A_i$ a la même structure que le module principal $M_i$. Pour j variant de 0 à M-1, chaque référence $SW_{i,2j}$, $S_{i,2j}$, $SW_{i,2j+1}$ et $S_{i,2j+1}$ utilisée pour le module principal Mi est remplacée respectivement par les références $SW_{i,2M+2j}$, $S_{i,2M+2j}$, $SW_{i,2M+2j+1}$ et $S_{i,2M+2j+1}$ pour le module auxiliaire $A_i$. En outre, la référence $C_{Ii,0}$ utilisée pour le module principal Mi est remplacée par la référence $C_{Ii,1}$ et les références $SW_{i,4M}$ et $S_{i,4M}$ sont respectivement remplacées par les références $SW_{i,4M+1}$ et $S_{i,4M+1}$. Les secondes bornes des interrupteurs $SW_{i,4M+1}$ sont reliées à un noeud $N_2$.

L'étage terminal de décimation 32 du module 20 comprend un condensateur $C_{T0}$ ayant une première borne reliée au noeud $N_1$, et une seconde borne reliée au potentiel de référence GND. La première borne du condensateur $C_{T0}$ est reliée à une première borne d'un interrupteur $SW_{M,0}$, commandé par un signal de commande $S_{M,0}$, et dont la seconde borne est reliée à la borne OUT du module 20. L'étage terminal de décimation 32 comprend un condensateur $C_{T1}$ ayant une première borne reliée au noeud $N_2$, et une seconde borne reliée au potentiel de référence GND. La première borne du condensateur $C_{T1}$ est reliée à une première borne d'un interrupteur $SW_{M,1}$, commandé par un signal de commande $S_{M,1}$, dont la seconde borne est reliée à la borne de sortie OUT du module 20.

Le module 20 selon la présente invention comprend des moyens, non représentés, pour mettre à zéro ou à une valeur de repos constante non nulle, la charge stockée dans chaque condensateur.

Le principe de fonctionnement du premier étage 30 du module 20 selon l'invention va maintenant être décrit. Le courant fourni par la source de courant I est transmis à la borne IN du module 20 par l'interrupteur $SW_{RF}$ pendant une demi période $1/(2f_S)$ à la fréquence d'échantillonnage $f_S$. Pour chaque module de filtrage $F_i$, i variant de 0 à M-1, les interrupteurs $SW_{i,2j}$, j variant de 0 à M-1, sont commandés de sorte que, à chaque fermeture de l'interrupteur $SW_{RF}$, un condensateur $C_{Hi,j}$, j variant de 0 à 2M-1, soit relié à la borne IN. Le courant fourni par la source de courant I est alors intégré dans le condensateur $C_{Hi,j}$ relié à la borne IN. On obtient donc une conversion courant-charge (ou, de façon équivalente, une conversion courant-tension). Le traitement résultant sur le signal analogique initial équivaut donc à un filtrage SINC, pour lequel les lobes de la réponse fréquentielle ont une largeur $2f_S$, suivi d'un échantillonnage et d'un maintien de la valeur échantillonnée. La largeur de bande du signal analogique initial étant généralement nettement inférieure à $f_S$, un tel traitement n'a pratiquement pas d'effet sur le signal obtenu. On obtient donc le stockage d'un échantillon du signal analogique initial au niveau du condensateur $C_{Hi,j}$.

Pour chaque module de filtrage $F_i$, les condensateurs $C_{Hi,j}$, jvariant de 0 à M-1, du module principal Mi sont utilisés pour stocker M échantillons successifs du signal analogique initial. Les condensateurs $C_{Hi,M+j}$, j Variant de 0 à M-1 du module auxiliaire $A_i$ sont alors utilisés pour stocker les M échantillons suivants du signal analogique initial. Pendant que M échantillons sont stockés au niveau du module auxiliaire $A_i$, les M échantillons précédemment stockés au niveau du module principal $M_i$ sont fournis simultanément au condensateur $C_{Ii,0}$ qui réalise une intégration sur les M échantillons stockés. De façon analogue, quand M échantillons sont stockés au niveau du module principal $M_i$, les M échantillons précédemment stockés au niveau du module auxiliaire $A_i$ sont fournis simultanément au condensateur $C_{Ii,1}$ qui réalise une intégration sur les M échantillons stockés. Chaque module de filtrage $F_i$, i variant de 0 à M-1, fonctionne de façon analogue, mais avec un décalage d'une période d'échantillonnage entre chaque module de filtrage $F_i$. Les M modules de filtrage $F_i$, i variant de 0 à M-1, étant décalés d'une période d'échantillonnage, les condensateurs d'intégration $C_{Ii,0}$ sont adaptés à fournir de nouvelles valeurs filtrées à la fréquence d'échantillonnage. Ceci correspond donc globalement à la réalisation d'une moyenne glissante de longueur M sans décimation.

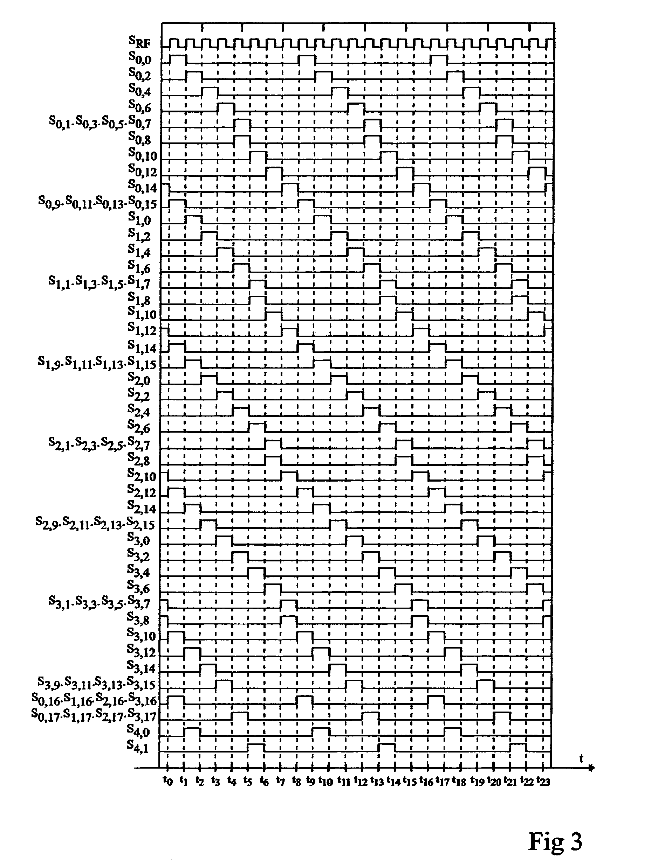

La figure 3 représente un exemple de chronogramme détaillé des signaux de commande des interrupteurs du module 20 de la figure 2 qui illustre la description qui précède. Les instants $t_0$ à $t_{23}$ représentent des instants successifs. Par la suite, on considère qu'un interrupteur est fermé lorsque le signal de commande correspondant est à l'état haut, et est ouvert lorsque le signal de commande est à l'état bas. La description suivante illustre plus particulièrement le fonctionnement du module de filtrage $F_0$.

A l'instant $t_0$, l'interrupteur $SW_{0,0}$ est fermé, entraînant l'intégration dans le condensateur $C_{H0,0}$ du courant fourni à la borne d'entrée IN. Les interrupteurs $SW_{0,2}$, $SW_{0,4}$ et $SW_{0,6}$ sont ouverts. De même, les interrupteurs $SW_{0,1}$, $SW_{0,3}$, $SW_{0,5}$ et $SW_{0,7}$ sont ouverts. Les interrupteurs $SW_{0,8}$, $SW_{0,10}$, $SW_{0,12}$ et $SW_{0,14}$ sont ouverts et les interrupteurs $SW_{0,9}$, $SW_{0,11}$, $SW_{0,13}$ et $SW_{0,15}$ sont fermés, entraînant le partage des charges stockées dans les condensateurs $C_{H0,4}$, $C_{H0,5}$ $C_{H0,6}$ et $C_{H0,7}$ et le condensateur d'intégration $C_{I0,1}$. La charge finalement stockée au niveau du condensateur

$C_{I0,1}$ est donc représentative de la moyenne des quatre charges stockées dans les condensateurs $C_{H0,4}$, $CH_{0,5}$, $C_{H0,6}$ et $C_{H0,7}$.

A l'instant $t_1$, les interrupteurs $SW_{0,9}$, $SW_{0,11}$, $SW_{0,13}$ et $SW_{0,15}$ sont ouverts. L'interrupteur $SW_{0,0}$ est ouvert, tandis que l'interrupteur $SW_{0,2}$ est fermé, entraînant l'intégration du courant fourni par la source de courant I dans le condensateur $C_{H0,1}$. Parallèlement, les charges stockées par les condensateurs $C_{H0,4}$, $C_{H0,5}$, $C_{H0,6}$ et $C_{H0,7}$ sont remises à zéro.

A l'instant $t_2$, l'interrupteur $SW_{0,2}$ est ouvert et l'interrupteur $SW_{0,4}$ est fermé entraînant l'intégration du courant fourni par la source de courant I dans le condensateur $C_{H0,2}$.

A l'instant $t_3$, l'interrupteur $SW_{0,4}$ est ouvert, et l'interrupteur $SW_{0,6}$ est fermé entraînant l'intégration du courant fourni par la source de courant I dans le condensateur $C_{H0,3}$.

A l'instant $t_4$, l'interrupteur $SW_{0,8}$ est fermé entraînant l'intégration du courant fourni par la source de courant I dans le condensateur $C_{H0,4}$. Parallèlement, les interrupteurs $SW_{0,1}$, $SW_{0,3}$, $SW_{0,5}$ et $SW_{0,7}$ sont fermés entraînant le partage des charges stockées dans les condensateurs $C_{H0,0}$, $C_{H0,1}$, $C_{H0,2}$ et $C_{H0,3}$ et le condensateur d'intégration $C_{I0,0}$. La charge résultante stockée dans le condensateur $C_{I0,0}$ est donc représentative de la moyenne des charges stockées dans les condensateurs $C_{H0,0}$, $C_{H0,1}$, $C_{H0,2}$ et $C_{H0,3}$.

A l'instant $t_5$, l'interrupteur $SW_{0,8}$ est ouvert et l'interrupteur $SW_{0,10}$ est fermé entraînant l'intégration du courant fourni par la source I dans le condensateur $C_{H0,5}$. Parallèlement, les charges stockées dans les condensateurs $C_{H0,0}$, $C_{H0,1}$, $C_{H0,2}$ et $C_{H0,3}$ sont remises à zéro.

A l'instant $t_6$, l'interrupteur $SW_{0,10}$ est ouvert et l'interrupteur $SW_{0,12}$ est fermé entraînant l'intégration du courant fourni par la source de courant I dans le condensateur $C_{H0,6}$.

A l'instant $t_7$, l'interrupteur $SW_{0,12}$ est ouvert et l'interrupteur $SW_{0,14}$ est fermé entraînant l'intégration du courant fourni par la source de courant I dans le condensateur $C_{H0,7}$.

De l'instant $t_8$ à l'instant $t_{15}$ et de l'instant $t_{16}$ à l'instant $t_{23}$, les interrupteurs associés au module de filtrage F1 sont commandés selon la même séquence que celle mise en oeuvre de l'instant $t_0$ à l'instant $t_7$.

Les interrupteurs associés aux modules de filtrage $F_1$ à $F_3$ sont actionnés selon la même séquence que les interrupteurs associés au module de filtrage $F_0$, mais avec un décalage d'un cycle d'horloge d'échantillonnage l'un par rapport à l'autre. C'est-à-dire que les interrupteurs associés au module de filtrage $F_1$ sont commandés avec un décalage d'un cycle d'horloge d'échantillonnage par rapport au module de filtrage $F_0$. A titre d'exemple, de l'instant $t_1$ à l'instant $t_8$, les interrupteurs associés au module de filtrage $F_1$ sont commandés selon la même séquence que celle mise en oeuvre pour les interrupteurs correspondants du module de filtrage $F_0$ de l'instant $t_0$ à l'instant $t_7$. Les interrupteurs associés au module de filtrage $F_2$ sont actionnés avec un décalage de deux cycles d'horloge d'échantillonnage par rapport au module de filtrage $F_0$. A titre d'exemple, de l'instant $t_2$ à l'instant $t_9$, les interrupteurs associés au module de filtrage $F_2$ sont commandés selon la même séquence que celle mise en oeuvre pour les interrupteurs correspondants du module de filtrage $F_0$ de l'instant $t_0$ à l'instant $t_7$. Les interrupteurs associés au module de filtrage $F_3$ sont actionnés avec un décalage de trois cycles d'horloge d'échantillonnage par rapport au module de filtrage $F_0$. A titre d'exemple, de l'instant $t_3$ à l'instant $t_{10}$, les interrupteurs associés au module de filtrage $F_3$ sont commandés selon la même séquence que celle mise en oeuvre pour les interrupteurs correspondants du module de filtrage $F_0$ de l'instant $t_0$ à l'instant $t_7$.

Pour chaque module de filtrage $F_i$, i variant de 0 à M-1, chaque condensateur d'intégration $C_{Ii,0}$ réalise une somme sur M échantillons successifs, suivie par une décimation de rapport M, c'est-à-dire qu'il réalise l'intégration de M échantillons et fournit le résultat, puis réalise l'intégration de M autres échantillons successifs et fournit le nouveau résultat, etc. Toutefois, il y a un décalage d'un échantillon entre le condensateur d'intégration $C_{I1,0}$ et le condensateur d'intégration $C_{I0,0}$, un décalage de deux échantillons entre le condensateur d'intégration $C_{I2,0}$ et le condensateur d'intégration $C_{I0,0}$ et un décalage de trois échantillons entre le condensateur d'intégration $C_{I3,0}$ et le condensateur d'intégration $C_{I0,0}$. Ainsi, pour M cycles d'horloge d'échantillonnage successifs, M nouvelles valeurs sont stockées respectivement dans les condensateurs d'intégration $C_{Ii,0}$, i variant de 0 à M-1. L'opération ainsi obtenue correspond donc à une moyenne glissante de longueur M sans décimation. Pour les M cycles d'horloge d'échantillonnage suivants, la même opération est obtenue avec les condensateurs d'intégration $C_{Ii,1}$, i variant de 0 à M-1.

De façon plus détaillée pour le module de filtrage $F_0$, à l'instant $t_4$, comme cela a été décrit précédemment, les interrupteurs $SW_{0,1}$, $SW_{0,3}$, $SW_{0,5}$ et $SW_{0,7}$ sont fermés. Les condensateurs $C_{H0,0}$, $C_{H0,1}$, $C_{H0,2}$, $C_{H0,3}$ et $C_{I0,0}$ partagent donc leur charge. La charge finale stockée dans le condensateur $C_{I0,0}$ est donc proportionnelle à la somme des charges stockées dans les quatre condensateurs $C_{H0,0}$, $C_{H0,1}$, $C_{H0,2}$, $C_{H0,3}$. On réalise ainsi la somme de quatre échantillons successifs. Parallèlement (et éventuellement pendant les trois cycles d'horloge d'échantillonnage suivants), l'interrupteur $SW_{0,17}$ est fermé. La charge stockée dans le condensateur $C_{I0,1}$ est alors lue puis remise à zéro. Quatre cycles d'horloge d'échantillonnage plus tard, à l'instant $t_8$, les interrupteurs $SW_{0,9}$, $SW_{0,11}$, $SW_{0,13}$ et $SW_{0,15}$ sont fermés. Les condensateurs $C_{H0,4}$, $C_{H0,5}$, $C_{H0,6}$, $C_{H0,7}$ et $C_{I0,1}$ partagent donc leur charge. La charge stockée par le condensateur $C_{I0,1}$ est donc proportionnelle à la somme des charges stockées dans les quatre condensateurs $C_{H0,4}$, $C_{H0,5}$, $C_{H0,6}$, $C_{H0,7}$. On réalise ainsi la somme des quatre échantillons successifs suivants. Parallèlement, ou pendant les trois cycles d'horloge d'échantillonnage suivants, la charge contenue dans le condensateur $C_{I0,0}$ est lue en fermant l'interrupteur $SW_{0,16}$ puis est remise à zéro. Un fonctionnement analogue est réalisé pour les autres modules de filtrage $F_1$, $F_2$ et $F_3$ avec le décalage de cycles d'horloge d'échantillonnage précédemment mentionné.

Dans le présent exemple de réalisation, puisque l'étage 30 est relié directement à un étage de décimation 32, la commande des interrupteurs $SW_{i,16}$ et $SW_{i,17}$, i variant de 0 à M-1, est particulière.

Dans le cas où il n'y a pas de décimation, les 2M interrupteurs $SW_{i,16}$ et $SW_{i,17}$, i variant de 0 à M-1, sont connectés ensemble à un noeud commun au lieu d'être séparés en deux groupes comme dans le cas représenté en figure 2. Le noeud commun correspond alors à la sortie de l'étage. Les interrupteurs $SW_{i,16}$, i variant de 0 à M-1, sont fermés l'un après l'autre pendant quatre cycles successifs et les interrupteurs $SW_{i,17}$, i variant de 0 à M-1, sont fermés l'un après l'autre pendant les quatre cycles successifs suivants. L'étage général 30 fournit alors une nouvelle valeur filtrée à chaque cycle d'horloge d'échantillonnage.

Dans le présent exemple où l'étage 32 correspond à un étage terminal de décimation, les instants de lecture et de remise à zéro des condensateurs d'intégration sont différents de ce qui a été décrit au paragraphe précédent. Comme dans le cas précédent, on effectue l'intégration en parallèle de charges au niveau des M condensateurs d'intégration $C_{Ii,0}$, i variant de 0 à M-1, mais avec des décalages les uns par rapport aux autres. A titre d'exemple, à l'instant $t_4$, une intégration de M échantillons successifs est réalisée au niveau du condensateur $C_{I0,0}$. A l'instant $t_5$, une opération d'intégration avec un échantillon de décalage est réalisée au niveau du condensateur $C_{I1,0}$. A l'instant $t_6$, une opération d'intégration avec un échantillon de décalage est réalisée au niveau du condensateur $C_{I2,0}$ et finalement, à l'instant $t_7$, une opération d'intégration avec un échantillon de décalage est réalisée au niveau du condensateur $C_{I3,0}$. Une fois l'intégration réalisée au niveau du condensateur $C_{I0,0}$, la charge est maintenue, ainsi que celle sur les condensateurs $C_{I1,0}$ et $C_{I2,0}$, jusqu'à ce que l'opération d'intégration au niveau du condensateur $C_{I3,0}$ soit réalisée. A l'instant $t_8$, les interrupteurs $SW_{i,16}$, i variant de 0 à M-1, sont alors fermés simultanément, de sorte que les charges sur les condensateurs d'intégration $C_{Ii,0}$, i variant de 0 à M-1, soient mises en commun simultanément avec l'étage suivant. Au même moment, une opération d'intégration est réalisée au niveau du condensateur $C_{I0,1}$, puis c'est le tour successif des condensateurs $C_{I1,1}$, $C_{I2,1}$ et $C_{I3,1}$, respectivement aux instants $t_9$, $t_{10}$ et $t_{11}$. Lors de l'intégration au niveau du condensateur $C_{I1,1}$, les charges stockées dans les condensateurs $C_{Ii,0}$, i variant de 0 à M-1, sont remises à zéro. A l'instant $t_{12}$, les interrupteurs $SW_{i,17}$, i variant de 0 à M-1, sont fermés simultanément, et les condensateurs $C_{Ii,1}$, i variant de 0 à M-1, partagent simultanément leur charge avec l'étage suivant.

Le fonctionnement de l'étage de décimation 32 est le suivant. Lorsque les M interrupteurs $SW_{i,16}$, i variant de 0 à M-1, sont fermés, les M condensateurs $C_{Ii,0}$, i variant de 0 à M-1, partagent leur charge avec le condensateur $C_{T0}$. Ceci permet d'obtenir la somme des M échantillons contenus dans les condensateurs $C_{Ii,0}$, i variant de 0 à M-1, en réalisant une fonction de filtrage de type SINC. Puisqu'un seul échantillon est fourni à la borne de sortie OUT alors que M échantillons sont reçus à la borne d'entrée IN, on réalise une opération de décimation. Ainsi, pendant deux des sept cycles suivants, la charge stockée dans le condensateur $C_{T0}$ est lue par la fermeture de l'interrupteur $SW_{4,0}$ puis est remise à zéro (ou à une valeur de repos constante non nulle). Quatre cycles d'horloge après l'opération d'intégration au niveau du condensateur $C_{T0}$, les interrupteurs $SW_{i,17}$, i variant de 0 à M-1, sont fermés. La charge stockée dans le condensateur $C_{T1}$ est alors représentative de la somme des charges précédemment contenues dans les condensateurs $C_{Ii,1}$, i variant de 0 à M-1. Durant deux des sept cycles d'horloge suivants, la charge stockée dans le condensateur $C_{T1}$ est lue puis remise à zéro (ou à une valeur de repos constante non nulle).

La présente invention permet de réaliser un filtre uniquement par l'intermédiaire de composants passifs, ce qui permet d'en réduire la consommation.

En outre, dans le présent exemple de réalisation, la présente invention présente les avantages supplémentaires suivants.

Premièrement, la fonction de filtrage obtenue est relativement simple puisqu'elle consiste en la mise en cascade d'étages réalisant chacun une moyenne glissante.

Deuxièmement, la réponse impulsionnelle du filtre est sensiblement constituée de "1", ce qui évite la réalisation de combinaisons de condensateurs complexes ayant des capacités différentes.

Troisièmement, le filtre selon la présente invention est peu sensible aux variations des coefficients du filtre.

Quatrièmement, la fonction de filtrage obtenue est peu sensible aux valeurs absolues des capacités des condensateurs du filtre, puisque seul le rapport des capacités est à prendre en compte. Il est plus facile d'obtenir des rapports de capacités de valeurs précises que d'obtenir des valeurs précises pour les capacités elles-mêmes.

Cinquièmement, l'ordre du filtre selon la présente invention peut facilement être augmenté ou diminué. Ainsi, l'atténuation autour des zéros du filtre peut être ajustée suivant les besoins.

Sixièmement, la réponse fréquentielle du filtre selon la présente invention contient des zéros régulièrement espacés. Le filtre est donc particulièrement adapté pour empêcher un repliement du spectre avec une réjection élevée aux fréquences de repliement. Le présent filtre est donc particulièrement adapté pour la mise en oeuvre d'une opération de filtrage en combinaison avec une opération de décimation. Il suffit alors de choisir la fréquence d'échantillonnage de décimation égale à l'intervalle de fréquence entre les zéros de la réponse fréquentielle du filtre.

Selon une variante de réalisation de la présente invention, si la fréquence d'échantillonnage est suffisamment faible, les opérations d'intégration, de lecture et de remise à zéro précédemment décrites peuvent être réalisées pendant un seul cycle d'horloge d'échantillonnage. Dans ce cas, les modules auxiliaires $A_i$, i variant de 0 à M-1, de chaque module de filtrage $F_i$, peuvent être supprimés.

Selon une autre variante de la présente invention, les signaux de commande des interrupteurs, représentés en figure 3, sont mis à l'état haut pendant une durée égale à un cycle d'horloge d'échantillonnage. On comprendra que certains signaux de commande peuvent être maintenus à l'état haut sur une durée supérieure à celle d'un cycle d'échantillonnage. Par exemple, la fermeture de l'interrupteur $SW_{4,0}$, permettant la lecture de la charge stockée dans le condensateur $C_{T0}$, peut durer plus d'un cycle d'horloge. En effet, elle peut s'étendre sur sept cycles d'horloge, un cycle d'horloge étant utilisé pour la remise à zéro de la charge du condensateur $C_{T0}$. De façon plus générale, la durée de fermeture des interrupteurs est choisie pour parvenir à un compromis entre la consommation et le bruit rayonné, la bande passante du bruit rayonné étant d'autant plus large que la durée de mise à l'état haut des signaux de commande est courte.

Selon une autre variante de réalisation, les interrupteurs $SW_{i,16}$ et $SW_{i,17}$, i variant de 0 à M-1, sont connectés à un noeud commun. Dans ce cas, ce noeud est relié aux condensateurs $C_{T0}$ et $C_{T1}$ par deux interrupteurs distincts. Lorsqu'une opération d'intégration doit être réalisée au niveau du condensateur $C_{T0}$, c'est-à-dire lors de la fermeture des interrupteurs $SW_{i,16}$, i variant de 0 à M-1, l'interrupteur reliant le noeud commun au condensateur $C_{T0}$ est alors fermé, l'interrupteur reliant le noeud commun au condensateur $C_{T1}$ étant ouvert. Lorsqu'une opération d'intégration doit être réalisée au niveau du condensateur $C_{T1}$, c'est-à-dire lors de la fermeture des interrupteurs $SW_{i,17}$, i variant de 0 à M-1, l'interrupteur reliant le noeud commun au condensateur $C_{T1}$ est alors fermé, l'interrupteur reliant le noeud commun au condensateur $C_{T0}$ étant ouvert.

La présente invention a été décrite pour la réalisation d'une opération de filtrage et de décimation. Toutefois, un filtre, constitué de plusieurs étages généraux de filtre, peut être utilisé pour réaliser une opération d'interpolation. Dans ce cas, le premier étage du filtre est remplacé par un étage de duplication des signaux échantillonnés reçus par le filtre.

La présente invention a été décrite pour la réalisation d'une fonction de filtrage de type SINC d'un ordre quelconque. Toutefois, la structure de filtre précédemment décrite peut être adaptée pour réaliser un filtre à réponse impulsionnelle finie quelconque (filtre RIF ou en anglais FIR).

Pour ce faire, on conserve la structure de l'étage général de filtre précédemment décrite. Plus précisément, les modules de filtre $F_i$, i variant de 0 à M-1, sont identiques les uns aux autres et pour chaque module de filtre $F_i$, le module principal Mi est identique au module auxiliaire $A_i$. Autrement dit, pour i et j fixés, les capacités des condensateurs $C_{Hi,j}$ et $C_{Hi,M+j}$ sont identiques et pour i variant de 0 à M-1, les capacités des condensateurs $C_{Hi,j}$ sont identiques. Toutefois, pour le module principal $M_i$, les capacités des condensateurs $C_{Hi,j}$, j variant de 0 à M-1, sont choisies différentes les unes des autres.

Pour obtenir un filtre à réponse impulsionnelle finie quelconque, il est nécessaire d'attaquer un tel filtre par une charge stockée dans un condensateur d'entrée.

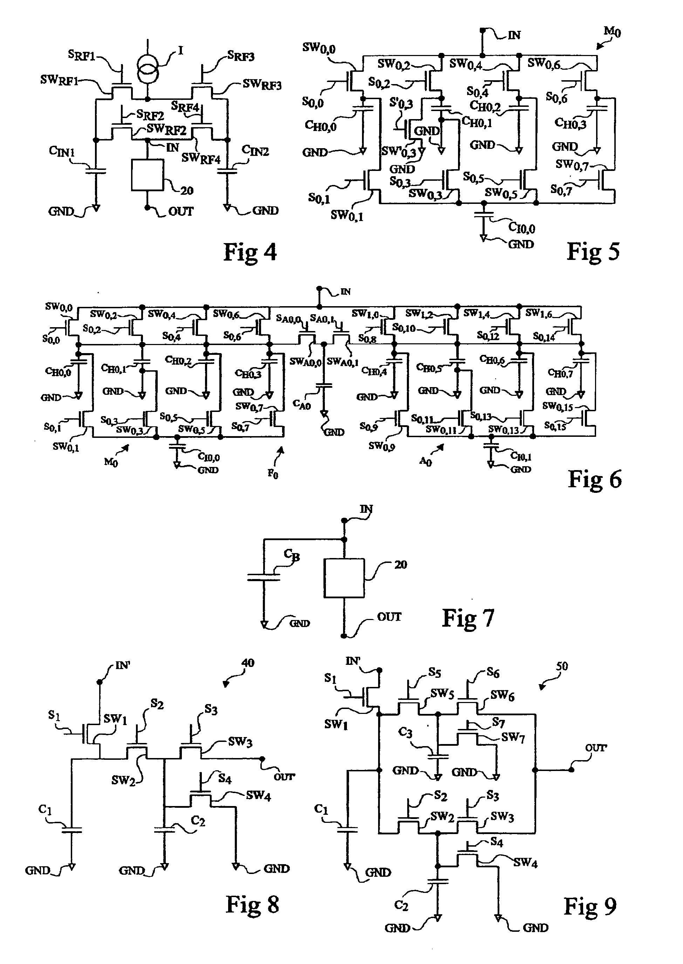

La figure 4 représente un exemple de réalisation d'un circuit permettant d'attaquer le filtre par une charge stockée dans un condensateur. Le circuit comprend un premier condensateur d'entrée $C_{IN1}$ dont une borne est reliée à la masse GND. L'autre borne du condensateur d'entrée $C_{IN1}$ est reliée à la sortie de la source de courant I par l'intermédiaire d'un interrupteur $SW_{RF1}$ commandé par le signal $S_{RF1}$ et à la borne d'entrée IN par l'intermédiaire d'un interrupteur $SW_{RF2}$ commandé par le signal $S_{RF2}$. Le circuit comprend un second condensateur d'entrée $C_{IN2}$ dont une borne est reliée à la masse GND. L'autre borne du condensateur d'entrée $C_{IN2}$ est reliée à la sortie de la source de courant I par l'intermédiaire d'un interrupteur $SW_{RF3}$ commandé par le signal $S_{RF3}$ et à la borne d'entrée IN par l'intermédiaire d'un interrupteur $SW_{RF4}$ commandé par le signal $S_{RF4}$. Les condensateurs $C_{IN1}$ et $C_{IN2}$ ont la même capacité $C_{IN}$. Les interrupteurs $SW_{RF1}$, $SW_{RF2}$, $SW_{RF3}$ et $SW_{RF4}$ sont commandés de façon qu'à un cycle d'horloge d'échantillonnage, le condensateur $C_{IN1}$ est relié à la sortie de la source de courant I tandis que le condensateur $C_{IN2}$ est relié à la borne d'entrée IN, et qu'au cycle d'horloge d'échantillonnage suivant, le condensateur $C_{IN2}$ est relié à la sortie de la source de courant I tandis que le condensateur $C_{IN1}$ est relié à la borne d'entrée IN. Le circuit comprend également des moyens, non représentés, pour mettre à zéro ou à une valeur de repos constante non nulle, la charge stockée dans chaque condensateur $C_{IN1}$ et $C_{IN2}$ après une lecture au travers de la borne d'entrée IN.

Dans le cas d'un filtre à plusieurs étages, les condensateurs d'entrée d'un étage du filtre autre que le premier étage correspondent aux condensateurs d'intégration de l'étage précédent.

A chaque cycle d'horloge d'échantillonnage, pour chaque module de filtrage $F_i$, i variant de 0 à M-1, un interrupteur $SW_{i,2j}$, j variant de 0 à M-1, est fermé. L'un des condensateurs d'entrée $C_{IN1}$, $C_{IN2}$ est donc relié simultanément à M condensateurs de tête de l'étage du filtre. La charge finale stockée dans chaque condensateur de tête est alors proportionnelle au produit de sa capacité et de la charge stockée initialement dans le condensateur d'entrée. Une opération d'échantillonnage étant réalisée ultérieurement au niveau du condensateur $C_{li,0}$ ou $C_{li,1}$ sur M échantillons successifs stockés au niveau du module de filtrage $F_i$, un tel étage réalise une fonction de filtrage dont la transformée en z est la suivante :

$$H(z) = \sum_{j=0}^{M-1} a_j z^{-1}$$

où le coefficient aj est proportionnel à la capacité du condensateur $C_{Hi, M-1-j}$. L'expression de $a_j$ est donnée par la relation suivante :

$$a_j = \frac{C_{Hi,M-1-j}}{C_{IN} + \sum_{j=0}^{j=M-1} C_{Hi,j}}$$

Par cette méthode, les coefficients $a_j$ obtenus sont positifs. Pour obtenir des coefficients négatifs, il suffit d'inverser la polarité du condensateur de tête correspondant $C_{Hi,j}$ au cours de l'opération de lecture.

La figure 5 illustre, à titre d'exemple, une variante de réalisation du filtre permettant l'obtention d'un coefficient $a_2$ négatif. Seul le module principal $M_0$ du module de filtrage $F_0$ est représenté en figure 5, la structure des autres modules auxiliaires et principaux étant la même. La borne du condensateur $C_{H0,1}$ reliée la masse GND est également reliée à l'interrupteur $SW_{0,3}$ et la borne du condensateur $C_{H0,1}$ reliée à l'interrupteur SW0,2 est également reliée à la masse GND par l'intermédiaire d'un interrupteur supplémentaire $SW'_{0,3}$ commandé par le signal $S'_{0,3}$. Pour la lecture de la charge stockée dans le condensateur $C_{H0,1}$, les signaux S'0,3 et S0,3 sont mis à un niveau haut. Il s'agit donc de l'inverse de la charge stockée dans le condensateur $C_{H0,1}$ qui est partagée avec le condensateur d'intégration $C_{I0,0}$.

En prévoyant plusieurs étages en cascade, on peut donc obtenir un filtre FIR quelconque.

Lors de la réalisation d'un filtre à réponse impulsionnelle finie quelconque, les capacités des condensateurs $C_{Hi,j}$, i variant de 0 à M-1 et j variant de 0 à 2M-1, sont différentes. Il peut néanmoins être souhaitable que la capacité vue de l'entrée soit constante. On ajoute alors, en parallèle à chaque condensateur $C_{Hi,j}$, un condensateur supplémentaire de sorte que la somme de la capacité du condensateur $C_{Hi,j}$ et de la capacité du condensateur supplémentaire associé soit constante et identique pour chaque paire condensateur $C_{Hi,j}$-condensateur supplémentaire pour i variant de 0 à M-1 et j variant de 0 à 2M-1. Lorsque le condensateur $C_{Hi,j}$ est relié à la borne d'entrée IN, le condensateur supplémentaire associé l'est également. Toutefois, seul le condensateur $C_{Hi,j}$ est relié au condensateur d'intégration $C_{Ii,0}$ ou $C_{ji,1}$ associé pour obtenir la fonction de filtrage précédemment décrite.

De plus, la structure de filtre précédemment décrite peut être adaptée pour réaliser un filtre à réponse impulsionnelle infinie quasiment quelconque (filtre RII ou en anglais IIR). Plusieurs modifications à la structure de l'étage général du filtre précédemment décrite peuvent être prévues pour ajouter des pôles à la réponse fréquentielle du filtre.

Une première modification consiste, pour chaque module de filtrage $F_i$, i variant entre 0 et M-1, du filtre, à ne pas remettre à zéro la charge stockée au niveau du condensateur d'intégration $C_{Ii,0}$ ou $C_{Ii,1}$. Ceci revient à multiplier la transformée en z de l'étage général de filtre par le terme récursif H' suivant :

$$H'(z) = \frac{\alpha z^{-1}}{1 - \alpha z^{-M}} \quad \text{avec} \quad \alpha = \frac{1}{1 + M \dfrac{C_H}{C_I}}$$

où $C_H$ est la capacité, identique dans le cas d'un filtre SINC, des condensateurs $C_{Hi,j}$,j variant de 0 à 2M-1, et $C_I$ est la capacité du condensateur d'intégration $C_{Ii,0}$ ou $C_{Ii,1}$. Un terme récursif peut être adjoint à chaque étage du filtre, le terme récursif pouvant être modifié pour chaque étage du filtre par le choix du rapport $C_H/C_I$ qui peut être différent pour chaque étage du filtre.

La figure 6 illustre une deuxième modification qui consiste, pour chaque module de filtrage $F_i$, i variant de 0 à M-1, à prévoir un condensateur additionnel $C_{Ai}$ connecté en parallèle aux condensateurs $C_{Hi,j}$, j variant de 0 à M-1 du module principal Mi et aux condensateurs CH$_{i,j}$, j variant de M à 2M-1, du module auxiliaire $A_i$. Les condensateurs $C_{Ai}$, i variant de 0 à M-1, ont la même capacité $C_A$. En figure 6, seul le module de filtrage $F_0$ est représenté à titre d'exemple, les autres modules ayant une structure similaire. Une borne du condensateur additionnel $C_{A0}$ est reliée à la masse GND. L'autre borne du condensateur $C_{A0}$ est reliée, par l'intermédiaire d'un interrupteur $SW_{A0,0}$, commandé par le signal

$S_{A0,0}$, à la borne de chaque condensateur $CH_{0,0}$, $C_{H0,1}$, $C_{H0,2}$ et $C_{H0,3}$ non reliée à la masse GND et est reliée, par l'intermédiaire d'un interrupteur $SW_{A0,1}$, commandé par le signal $S_{A0,1}$, à la borne de chaque condensateur $C_{H0,4}$, $C_{H0,5}$, $C_{H0,6}$ et $C_{H0,7}$ non reliée à la masse GND. Les interrupteurs associés au condensateur additionnel $C_{Ai}$ sont commandés de sorte que le condensateur additionnel $C_{Ai}$ soit connecté, à un instant donné, seulement aux condensateurs de l'un des modules $M_i$ ou $A_i$ qui est alors relié à la borne d'entrée IN du filtre et pas aux condensateurs de tête de l'autre module $M_i$ ou $A_i$ qui participe alors à une opération d'intégration au niveau du condensateur d'intégration ou de remise à zéro des charges des condensateurs de tête. La charge du condensateur $C_{Ai}$ n'est jamais remise à zéro. Ceci revient à multiplier la transformée en z de l'étage de filtre par le terme récursif H' suivant :

$$H'(z) = \frac{(1-\alpha)z^{-1}}{1-\alpha z^{-1}} \quad \text{avec} \quad \alpha = \frac{C_A}{C_A + C_H}$$

La figure 7 illustre une troisième modification qui consiste à prévoir un condensateur additionnel $C_B$ dont une borne est reliée à la masse GND et dont l'autre borne est reliée en permanence à la borne d'entrée IN. La charge du condensateur $C_B$ n'est jamais remise à zéro. Ceci revient à multiplier la transformée en z de l'étage de filtre par le terme récursif H" suivant :

$$H''(z) = \frac{(1-\alpha)z^{-1}}{1-\alpha z^{-1}} \quad \text{avec} \quad \alpha = \frac{C'_B}{C'_B + MC_H}$$

où $C'_B$ est la capacité du condensateur additionnel $C_B$. Pour obtenir le même pôle qu'avec la deuxième modification précédemment décrite, il suffit de choisir un condensateur $C_B$ dont la capacité $C'_B$ est M fois plus importante que la capacité $C_A$ précédemment mentionnée. La taille du circuit obtenu avec le condensateur $C_B$ de capacité $M*C_A$ est donc sensiblement la même que celle qui est obtenue avec M condensateurs $C_{Ai}$, i variant de 0 à M-1, de capacité $C_A$. Toutefois, par rapport à la deuxième modification précédemment décrite, on économise 2M interrupteurs. Le circuit obtenu est donc plus simple, moins bruyant et moins consommateur que celui obtenu avec la deuxième modification.

La figure 8 représente un exemple de réalisation d'un circuit qui, de façon plus générale, permet d'ajouter un pôle unique à un étage du filtre. Le circuit à pôle unique 40 peut être ajouté avant ou après un étage du filtre. Le circuit à pôle unique 40 comprend deux condensateurs $C_1$ et $C_2$ de capacité respectivement $C'_1$ et $C'_2$. Une borne du condensateur $C_1$ est reliée à la masse GND et l'autre borne du condensateur $C_1$ est reliée à une borne d'entrée IN' par l'intermédiaire d'un interrupteur $S_{W1}$ commandé par le signal $S_1$. Une borne du condensateur $C_2$ est reliée à la masse GND et l'autre borne du condensateur $C_2$ est reliée au point milieu entre le condensateur $C_1$ et l'interrupteur $SW_1$ par l'intermédiaire d'un interrupteur $SW_2$ commandé par le signal S2. Le point milieu entre l'interrupteur $SW_2$ et le condensateur $C_2$ est relié à une borne de sortie OUT' par l'intermédiaire d'un interrupteur $SW_3$ commandé par le signal $S_3$. Le point milieu entre l'interrupteur $SW_2$ et le condensateur $C_2$ est relié à la masse GND par l'intermédiaire d'un interrupteur $SW_4$ commandé par le signal $S_4$.

Les interrupteurs $SW_1$ à $SW_4$ sont commandés pour mettre à zéro (ou à une valeur de repos constante non nulle) la charge stockée dans le condensateur $C_2$ après lecture de cette charge, à chaque coup d'horloge d'échantillonnage, tandis que la charge stockée dans le condensateur $C_1$ n'est jamais remise à zéro. La transformée H' en z d'un tel circuit à pôle unique est la suivante :

$$H'(z) = \frac{(1-\alpha)z^{-1}}{(1-\alpha z^{-1})} \quad \text{où} \quad \alpha = \frac{C'_1}{C'_1 + C'_2}$$

En mettant en cascade un filtre RIF quelconque, tel que décrit précédemment, avec autant de circuits à pôle unique que nécessaire, on obtient un filtre RII pratiquement quelconque. La seule restriction est qu'on ne peut pas, de cette façon, obtenir un filtre ayant des pôles complexes conjugués, ni des pôles réels positifs.

La figure 9 illustre une variante du circuit de la figure 8. Outre les composants du circuit 40 représenté en figure 8, le circuit à pôle unique 50 comprend un condensateur $C_3$ dont une borne est reliée à la masse GND et dont l'autre borne est reliée au point milieu entre le condensateur $C_1$ et l'interrupteur $SW_1$ par l'intermédiaire d'un interrupteur $SW_5$ commandé par le signal S5. Le point milieu entre l'interrupteur $SW_5$ et le condensateur $C_3$ est relié à la borne de sortie OUT' par l'intermédiaire d'un interrupteur $SW_6$ commandé par le signal $S_6$. Le point milieu entre l'interrupteur $SW_5$ et le condensateur $C_3$ est relié à la masse GND par l'intermédiaire d'un interrupteur $SW_7$ commandé par le signal $S_7$. Le condensateur $C_3$ est utilisé alternativement à la place du condensateur $C_2$, avec une périodicité de deux coups d'horloge d'échantillonnage. Cela permet de lire et de remettre à zéro (ou une valeur de repos constante non nulle) la charge stockée dans le condensateur $C_2$ (respectivement $C_3$) pendant que le condensateur C3 (respectivement $C_2$) est chargé depuis la borne d'entrée IN'.

En fonction de la fréquence d'échantillonnage, on peut prévoir un condensateur supplémentaire $C_4$ (non représenté) monté de façon analogue aux condensateurs $C_2$ et $C_3$. Pendant que l'un des condensateurs $C_2$, $C_3$ ou $C_4$ est chargé, la charge stockée par le condensateur suivant est lue et la charge stockée par le dernier condensateur est remise à zéro (ou à une valeur de repos constante non nulle). Chacun des condensateurs joue le même rôle avec une rotation circulaire des rôles et une périodicité de trois coups d'horloge.

Bien entendu, la présente invention est susceptible de diverses variantes et modifications qui apparaîtront à l'homme de l'art. En particulier, dans les exemples de réalisation précédemment décrits, les interrupteurs sont réalisés par l'intermédiaire de transistors MOS. Toutefois, les interrupteurs pourraient être réalisés différemment, par exemple par l'intermédiaire de transistors bipolaires.

**Revendications**

1. Filtre (20) destiné à recevoir, sur une borne d'entrée (IN), un signal à temps discret à une fréquence d'horloge d'échantillonnage, comprenant au moins un étage de filtrage (30) comportant un nombre déterminé, supérieur à 2, de modules de filtrage ($F_i$), chaque module de filtrage comprenant:

   - des condensateurs de tête ($C_{Hi,0}$, $C_{Hi,1}$, $C_{Hi,2}$, $C_{Hi,3}$) en nombre égal au nombre déterminé, montés en parallèle entre la borne d'entrée et la borne d'un condensateur d'intégration ($C_{Ii,0}$) reliée à une borne de sortie ($N_1$) de l'étage de filtrage ; et
   - des moyens ($SW_{i,0}$, $SW_{i,2}$, $SW_{i,4}$, $SW_{i,6}$, $SW_{i,1}$, $SW_{i,3}$, $SW_{i,5}$, $SW_{i,7}$) pour relier, au cours de cycles d'horloge successifs en nombre égal au nombre déterminé, successivement chaque condensateur de tête à la borne d'entrée, et pour alors relier simultanément les condensateurs de tête au condensateur d'intégration,

   et dans lequel les cycles d'horloge successifs au cours desquels les condensateurs de tête d'un module de filtrage sont reliés à la borne d'entrée sont décalés d'un cycle d'horloge d'un module de filtrage au suivant.

2. Filtre selon la revendication 1, comprenant des moyens ($SW_{0,16}$, $SW_{1,16}$, $SW_{2,16}$, $SW_{3,16}$) Pour relier successivement chaque condensateur d'intégration ($C_{I0,0}$, $C_{I1,0}$, $C_{I2,0}$, $C_{I3,0}$) à la borne de sortie ($N_1$) à la fréquence d'échantillonnage.

3. Filtre selon la revendication 1, comprenant en outre, pour chaque module de filtrage ($F_i$), un étage de décimation (32) relié à la borne de sortie ($N_1$) de l'étage de filtrage, et comportant un condensateur ($C_{T0}$), l'étage de filtrage comprenant des moyens ($SW_{0,16}$, $SW_{1,16}$, $SW_{2,16}$ $SW_{3,16}$) pour relier simultanément les condensateurs d'intégration ($C_{I0,0}$, $C_{I1,0}$, $C_{I2,0}$, $C_{I3,0}$) au condensateur de l'étage de décimation.

4. Filtre selon la revendication 1, comprenant, pour chaque module de filtrage ($F_i$), des moyens pour mettre à une valeur constante déterminée la charge stockée dans chaque condensateur de tête ($C_{Hi,0}$, $C_{Hi,1}$, $C_{Hi,2}$, $C_{Hi,3}$) après que les condensateurs de tête sont reliés au condensateur d'intégration ($C_{Ii,0}$).

5. Filtre selon la revendication 1, dans lequel les capacités des condensateurs de tête ($C_{Hi,0}$, $C_{Hi,1}$, $C_{Hi,2}$, $C_{Hi,3}$) sont identiques pour tous les modules de filtrage ($F_0$, $F_1$, $F_2$, $F_3$), ledit étage de filtrage (30) réalisant un filtrage à moyenne glissante non pondérée.

6. Filtre selon la revendication 1, comprenant, pour chaque module de filtrage ($F_i$), des moyens pour mettre à une valeur constante déterminée la charge stockée dans le condensateur d'intégration ($C_{Ii,0}$) après que le condensateur d'intégration est relié à la borne de sortie ($N_1$).

7. Filtre selon la revendication 1, dans lequel, pour chaque module de filtrage ($F_i$), les capacités des condensateurs de tête ($C_{Hi,0}$, $C_{Hi,1}$, $C_{Hi,2}$, $C_{Hi,3}$) sont différentes, les modules de filtrage ($F_0$, $F_1$, $F_2$, $F_3$) étant identiques, ledit étage de filtrage (30) réalisant un filtrage à moyenne glissante pondérée.

**8.** Filtre selon la revendication 1, comprenant, pour au moins un condensateur de tête ($C_{Hi,0}$, $C_{Hi,1}$, $C_{Hi,2}$, $C_{Hi,3}$) de chaque module de filtrage ($F_i$), un moyen ($SW'_{0,3}$, $SW_{0,3}$) pour, lorsque ledit condensateur de tête est relié simultanément avec les autres condensateurs de tête du module de filtrage au condensateur d'intégration du module de filtrage, fournir au condensateur d'intégration l'inverse de la charge du condensateur de tête.

**9.** Filtre selon la revendication 1, comprenant un condensateur supplémentaire unique ($C_B$) comportant une borne connectée à la borne d'entrée (IN) et une autre borne connectée à une source d'un potentiel de référence (GND), la charge stockée dans le condensateur supplémentaire unique n'étant pas remise à une valeur constante déterminée au cours du fonctionnement du filtre.

**10.** Filtre selon la revendication 4, comprenant, pour chaque module de filtrage ($F_i$), un condensateur supplémentaire monté en parallèle aux condensateurs de tête ($C_{Hi,0}$, $C_{Hi,1}$, $C_{Hi,2}$, $C_{Hi,3}$), et des moyens, pendant tous les cycles d'horloge successifs au cours desquels les condensateurs de tête sont reliés à la borne d'entrée (IN), pour relier le condensateur supplémentaire à la borne d'entrée, la charge stockée dans le condensateur supplémentaire n'étant pas remise à zéro après que les condensateurs de tête sont reliés au condensateur d'intégration ($C_{Ii,0}$).

**11.** Filtre selon la revendication 1, comprenant, pour chaque module de filtrage ($F_i$) :

- des condensateurs de tête auxiliaires ($C_{Hi,4}$, $C_{Hi,5}$, $C_{Hi,6}$, $C_{Hi,7}$) en nombre égal au nombre déterminé, montés en parallèle entre la borne d'entrée (IN) et la borne d'un condensateur d'intégration auxiliaire ($C_{Ii,1}$) reliée à une borne de sortie auxiliaire ($N_2$) de l'étage de filtrage ; et
- des moyens ($SW_{i,8}$, $SW_{i,10}$, $SW_{i,12}$, $SW_{i,14}$, $SW_{i,9}$, $SW_{i,11}$, $SW_{i,13}$, $SW_{i,15}$) pour, au cours des cycles d'horloge successifs en nombre égal au nombre déterminé qui suivent les cycles d'horloge successifs au cours desquels les condensateurs de tête ($C_{Hi,0}$, $C_{Hi,1}$, $C_{Hi,2}$, $C_{Hi,3}$) sont reliés à la borne d'entrée, relier successivement chaque condensateur de tête auxiliaire à la borne d'entrée, et pour alors relier simultanément les condensateurs de tête auxiliaires au condensateur d'intégration auxiliaire.

**12.** Récepteur cellulaire, notamment récepteur GSM ou récepteur WCDMA, comprenant au moins un filtre selon l'une quelconque des revendications 1 à 11.

**Claims**

**1.** A filter (20) intended to receive, on an input terminal (IN), a discrete time signal at a sampling clock frequency, comprising at least one filtering stage (30) comprising a determined number, greater than 2, of filtering units ($F_i$), each filtering unit comprising:

- head capacitors ($C_{Hi,0}$, $C_{Hi,1}$, $C_{Hi,2}$, $C_{Hi,3}$) in a number equal to the determined number, assembled in parallel between the input terminal and the terminal of an integration capacitor ($C_{Ii,0}$) connected to an output terminal ($N_1$) of the filtering stage; and
- means ($SW_{i,0}$, $SW_{i,2}$, $SW_{i,4}$, $SW_{i,6}$, $SW_{i,1}$, $SW_{i,3}$, $SW_{i,5}$, $SW_{i,7}$) for connecting, in successive clock cycles in a number equal to the determined number, successively each head capacitor to the input terminal, and for then simultaneously connecting the head capacitors to the integration capacitor,

and wherein the successive clock cycles during which the head capacitors of a filtering unit are connected to the input terminal are offset by one clock cycle from one filtering unit to the next one.

**2.** The filter of claim 1, comprising means ($SW_{0,16}$, $SW_{1,16}$, $SW_{2,16}$, $SW_{3,16}$) for successively connecting each integration capacitor ($C_{I0,0}$, $C_{I1,0}$, $C_{I2,0}$, $C_{I3,0}$) to the output terminal ($N_1$) at the sampling frequency.

**3.** The filter of claim 1, further comprising, for each filtering unit ($F_i$), a decimation stage (32) connected to the output terminal ($N_1$) of the filtering stage, and comprising a capacitor ($C_{T0}$), the filtering stage comprising means ($SW_{0,16}$, $SW_{1,16}$, $SW_{2,16}$, $SW_{3,16}$) for simultaneously connecting the integration capacitors ($C_{I0,0}$, $C_{I1,0}$, $C_{I2,0}$, $C_{I3,0}$) to the capacitor of the decimation stage.

**4.** The filter of claim 1, comprising, for each filtering unit ($F_i$), means for setting to a determined constant value the charge stored in each head capacitor ($C_{Hi,0}$, $C_{Hi,1}$, $C_{Hi,2}$, $C_{Hi,3}$) after the head capacitors are connected to the integration capacitor ($C_{Ii,0}$).

5. The filter of claim 1, wherein the capacitances of the head capacitors ($C_{Hi,0}$, $C_{Hi,1}$, $C_{Hi,2}$, $C_{Hi,3}$) are identical for all filtering units ($F_0$, $F_1$, $F_2$, $F_3$), said filtering stage (30) performing an unweighted running means filtering.

6. The filter of claim 1, comprising, for each filtering unit ($F_i$), means for setting to a determined constant value the charge stored in the integration capacitor ($C_{Ii,0}$) after the integration capacitor is connected to the output terminal ($N_1$).

7. The filter of claim 1, wherein, for each filtering unit ($F_i$), the capacitances of the head capacitors ($C_{Hi,0}$, $C_{Hi,1}$, $C_{Hi,2}$, $C_{Hi,3}$) are different, the filtering units ($F_0$, $F_1$, $F_2$, $F_3$) being identical, said filtering stage (30) performing a weighted running means filtering.

8. The filter of claim 1, comprising, for at least one head capacitor ($C_{Hi,0}$, $C_{Hi,1}$, $C_{Hi,2}$, $C_{Hi,3}$) of each filtering unit ($F_i$), means ($SW'_{0,3}$, $SW_{0,3}$) for, when said head capacitor is connected simultaneously with the other head capacitors of the filtering unit to the integration capacitor of the filtering unit, providing the integration capacitor with the inverse of the charge of the head capacitor.

9. The filter of claim 1, comprising a single additional capacitor ($C_B$) comprising a terminal connected to the input terminal (IN) and another terminal connected to a reference voltage source (GND), the charge stored in the single additional capacitor being not set back to a determined constant value during the filter operation.

10. The filter of claim 4, comprising, for each filtering unit ($F_i$), an additional capacitor assembled in parallel with the head capacitors ($C_{Hi,0}$, $C_{Hi,1}$, $C_{Hi,2}$, $C_{Hi,3}$), and means, during all the successive clock cycles in which the head capacitors are connected to the input terminal (IN), for connecting the additional capacitor to the input terminal, the charge stored in the additional capacitor being not set back to zero after the head capacitors are connected to the integration capacitor ($C_{Ii,0}$).

11. The filter of claim 1, comprising, for each filtering unit ($F_i$):

- auxiliary head capacitors ($C_{Hi,4}$, $C_{Hi,5}$, $C_{Hi,6}$, $C_{Hi,7}$) in a number equal to the determined number, assembled in parallel between the input terminal (IN) and the terminal of an auxiliary integration capacitor ($C_{Ii,1}$) connected to an auxiliary output terminal ($N_2$) of the filtering stage; and
- means ($SW_{i,8}$, $SW_{i,10}$, $SW_{i,12}$, $SW_{i,14}$, $SW_{i,9}$, $SW_{i,11}$, $SW_{i,13}$, $SW_{i,15}$) for, in the successive clock cycles in a number equal to the determined number which follow the successive clock cycles in which the head capacitors ($C_{Hi,0}$, $C_{Hi,1}$, $C_{Hi,2}$, $C_{Hi,3}$) are connected to the input terminal, successively connecting each auxiliary head capacitor to the input terminal, and for then simultaneously connecting the auxiliary head capacitors to the auxiliary integration capacitor.

12. A cellular receiver, such as a GSM or WCDMA receiver, comprising at least one filter according to any of claims 1-11.

**Patentansprüche**

1. Ein Filter (20), das gedacht ist, um an einem Eingangsanschluss (IN) ein diskretes Zeitsignal mit einer Abtasttaktfrequenz zu empfangen, wobei das Filter mindestens eine Filterstufe (30) aufweist, die eine bestimmte Anzahl, die größer ist als 2, von Filtereinheiten ($F_i$) aufweist, wobei jede Filtereinheit Folgendes aufweist:

- Kopfkondensatoren ($C_{Hi,0}$, $C_{Hi,1}$, $C_{Hi,2}$, $C_{Hi,3}$) in einer Anzahl, die gleich der bestimmten Anzahl ist, die parallel montiert sind, zwischen dem Eingangsschluss und dem Anschluss eines Integrationskondensators ($C_{Ii,0}$), der mit einem Ausgangsanschluss ($N_1$) der Filterstufe verbunden ist; und
- Mittel ($SW_{i,0}$, $SW_{i,2}$, $SW_{i,4}$, $SW_{i,6}$, $SW_{i,1}$, $SW_{i,3}$, $SW_{i,5}$, $SW_{i,7}$), um in aufeinanderfolgenden Taktzyklen in einer Anzahl, die gleich der bestimmten Anzahl ist, aufeinanderfolgend jeden Kopfkondensator mit dem Eingangsanschluss zu verbinden und um dann gleichzeitig die Kopfkondensatoren mit dem Integrationskondensator zu verbinden, und

wobei die aufeinanderfolgenden Taktzyklen, während deren die Kopfkondensatoren einer Filtereinheit mit dem Eingangsanschluss verbunden sind, um einen Taktzyklus von einer Filtereinheit zu der nächsten versetzt sind.

2. Filter nach Anspruch 1, das Mittel ($SW_{0,16}$, $SW_{1,16}$, $SW_{2,16}$, $SW_{3,16}$) aufweist zum aufeinanderfolgenden Verbinden von jedem Integrationskondensator ($C_{I0,0}$, $C_{I1,0}$, $C_{I2,0}$, $C_{I3,0}$) mit dem Ausgangsanschluss ($N_1$) bei der Abtastfre-

quenz.

3. Filter nach Anspruch 1, ferner aufweisend, für jede Filtereinheit ($F_i$) eine Dezimationsstufe (32), die mit dem Ausgangsanschluss ($N_1$) der Filterstufe verbunden ist, und einen Kondensator ($C_{T0}$) aufweisend, wobei die Filterstufe Mittel ($SW_{0,16}$, $SW_{1,16}$, $SW_{2,16}$, $SW_{3,16}$) aufweist zum gleichzeitigen Verbinden der Integrationskondensatoren ($C_{I0,0}$, $C_{I1,0}$, $C_{I2,0}$, $C_{I3,0}$) mit dem Kondensator der Dezimierungsstufe.

4. Filter nach Anspruch 1, das für jede Filtereinheit ($F_i$) Mittel aufweist zum Festlegen bzw Einstellen der in jedem Kopfkondensator ($C_{Hi,0}$, $C_{Hi,1}$, $C_{Hi,2}$, $C_{Hi,3}$) gespeicherten Ladung auf einen bestimmten konstanten Wert, und zwar nachdem die Kopfkondensatoren mit dem Integrationskondensator ($C_{Ii,0}$) verbunden sind

5. Filter nach Anspruch 1, wobei die Kapazitäten der Kopfkondensatoren ($C_{Hi,0}$, $C_{Hi,1}$, $C_{Hi,2}$, $C_{Hi,3}$) für alle Filtereinheiten ($F_0$, $F_1$, $F_2$, $F_3$) identisch sind, wobei die Filterstufe (30) eine Filterung mit ungewichtetem gleitenden Mittelwert durchführt.

6. Filter nach Anspruch 1, das für jede Filtereinheit ($F_i$) Mittel zum Einstellen bzw Festlegen, der in dem Integrationskondensator ($C_{Ii,0}$) gespeicherten Ladung auf einen bestimmten konstanten Wert aufweist, und zwar nachdem der Integrationskondensator mit dem Ausgangsanschluss ($N_1$) verbunden ist,

7. Filter nach Anspruch 1, wobei für jede Filtereinheit ($F_i$) die Kapazitäten der Kopfkondensatoren ($C_{Hi,0}$, $C_{Hi,1}$, $C_{Hi,2}$, $C_{Hi,3}$) unterschiedlich sind, wobei die Filtereinheiten ($F_0$, $F_1$, $F_2$, $F_3$) identisch sind, wobei die Filterstufe (30) eine Filterung mit gewichtetem laufenden Mittelwert ausführt

8. Filter nach Anspruch 1, das für mindestens einen Kopfkondensator ($C_{Hi,0}$, $C_{Hi,1}$, $C_{Hi,2}$, $C_{Hi,3}$) von jeder Filtereinheit ($F_i$) Mittel ($SW'_{0,3}$, $SW_{0,3}$) aufweist zum Vorsehen der Inversen der Ladung des Kopfkondensators für den Integrationskondensator, wenn der Kopfkondensator gleichzeitig mit den anderen Kopfkondensatoren der Filtereinheit mit dem Integrationskondensator der Filtereinheit verbunden ist

9. Filter nach Anspruch 1, das einen einzelnen zusätzlichen Kondensator ($C_B$) aufweist, der einen Anschluss aufweist, der verbunden ist, mit dem Eingangsanschluss (IN) und einem anderen Anschluss, der mit einer Referenzspannungsquelle (GND) verbunden ist, wobei die Ladung, die in dem einzelnen zusätzlichen Kondensator gespeichert ist, nicht auf einen bestimmten konstanten Wert während der Filteroperation zurückgesetzt wird,

10. Filter nach Anspruch 4, das für jede Filtereinheit ($F_i$) einen zusätzlichen Kondensator aufweist, der parallel mit den Kopfkondensatoren ($C_{Hi,0}$, $C_{Hi,1}$, $C_{Hi,2}$, $C_{Hi,3}$) montiert ist und Mittel aufweist zum Verbinden des zusätzlichen Kondensators mit dem Eingangsanschluss, und zwar während allen von den nachfolgenden Taktzyklen in denen die Kopfkondensatoren mit dem Eingangsanschluss (IN) verbunden sind, wobei die Ladung, die in dem zusätzlichen Kondensator gespeichert ist, nicht auf Null zurückgesetzt wird, nachdem die Kopfkondensatoren mit dem Integrationskondensator ($C_{Ii,0}$) verbunden sind.

11. Filter nach Anspruch 1, das für jede Filtereinheit ($F_i$) Folgendes aufweist:

   - Zusatz- bzw. Hilfskopfkondensatoren ($C_{Hi,4}$, $C_{Hi,5}$, $C_{Hi,6}$, $C_{Hi,7}$) in einer Anzahl, die gleich der bestimmten Anzahl ist, die montiert sind zwischen dem Eingangsanschluss (IN) und dem Anschluss eines Zusatzs- bzw Hilfsintegrationskondensators ($C_{Ii,1}$) der mit einem Zusatz- bzw. Hilfsausgangsanschluss ($N_2$) der Filterstufe verbunden ist, und
   - Mittel ($SW_{i,8}$, $SW_{i,10}$, $SW_{i,12}$, $SW_{i,14}$, $SW_{i,9}$, $SW_{i,11}$, $SW_{i,13}$, $SW_{i,15}$), um bei den aufeinanderfolgenden bzw. nachfolgenden Taktzyklen in einer Anzahl gleich der bestimmten Anzahl die den nachfolgenden Taktzyklen folgen, bei denen die Kopfkondensatoren ($C_{Hi,0}$, $C_{Hi,1}$, $C_{Hi,2}$, $C_{Hi,3}$) mit dem Eingangsanschluss verbunden sind, jeden Hilfskopfkondensator mit dem Eingangsanschluss aufeinanderfolgend bzw nachfolgend zu verbinden und um dann gleichzeitig die Hilfskopfkondensatoren mit dem Hilfsintegrationskondensator zu verbinden.

12. Ein zellularer Empfänger, wie zum Beispiel ein GSM oder WCDMA Empfänger, der mindestens ein Filter gemäß einem der Ansprüche 1 bis 11 aufweist

Fig 1

Fig 2

Fig 3

Fig 4

Fig 5

Fig 6

Fig 7

Fig 8

Fig 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030083033 A

**Littérature non-brevet citée dans la description**

- **G.M. JACOBS et al.** Design Techniques for MOS Switch Capacitor Ladder Filters. *IEEE Transactions on Circuits and Systems,* Décembre 1978, vol. CAS-25, 1014-1021